# EUROPEAN PATENT SPECIFICATION

(11) **EP 3 684 151 B1**
(45) Date of publication and mention of the grant of the patent: **26.04.2023**
(21) Application number: 18868981.4
(22) Date of filing: 15.10.2018
(51) Int. Cl.: H05K 7/20

(54) **HEAT DISSIPATION STRUCTURE, CABINET, AND COMMUNICATION SYSTEM**
WÄRMEABLEITUNGSSTRUKTUR, SCHRANK UND KOMMUNIKATIONSSYSTEM
STRUCTURE DE DISSIPATION DE CHALEUR, ARMOIRE ET SYSTÈME DE COMMUNICATION

(30) Priority: 16.10.2017 CN 201710958161; 29.11.2017 CN 201721628701 U
(43) Date of publication of application: 22.07.2020
(73) Proprietor: Huawei Technologies Co., Ltd., Longgang District Shenzhen, Guangdong 518129 (CN)
(72) Inventor: LI, Jiang, Shenzhen Guangdong 518129 (CN); WANG, Jun, Shenzhen Guangdong 518129 (CN); JIA, Lirui, Shenzhen Guangdong 518129 (CN)
(74) Representative: Grünecker Patent- und Rechtsanwälte PartG mbB
(86) International application number: PCT/CN2018/110259
(87) International publication number: WO 2019/076270

(56) References cited:
- CN-A- 101 453 856
- CN-A- 103 841 791
- CN-A- 105 592 667
- CN-B- 101 453 856
- CN-Y- 2 919 789
- JP-A- 2005 241 025
- US-A1- 2006 144 070
- US-A1- 2013 267 162
- US-A1- 2015 271 950

## Description

### TECHNICAL FIELD

This application relates to the field of heat dissipation technologies, and in particular, to a heat dissipation structure, a cabinet, and a communications system.

### BACKGROUND

To ensure that an electronic device mounted inside a cabinet can work normally and reliably within an allowable operating temperature range, the cabinet needs to have a particular heat dissipation function, to transfer heat generated by the electronic device to the outside of the cabinet.
US 2006/144070 A1 discloses a refrigerating unit with one group of flow chambers connected to the interior of a housing comprising an electronic device and another group of flow chambers connected to the environment. Sealing fins sealing individual chambers between the back rear wall and the front wall of the refrigerating unit and fins closing one group of chambers at areas of inflow and outflow of the refrigerating unit are provided. JP 2005 241025 A discloses a heat exchanger for dissipating heat from a control panel wherein the heat exchanger comprises a plurality of channels for circulating hot air and a plurality of channels for guiding fresh air. US 2015/271950 A1 discloses a housing for an electronic device with heat dissipation structures allowing for the circulation of hot air. CN 101453856 B discloses a communication equipment cabinet with an electronic device arranged in the cabinet and an internal air channel exchanging heat with an external air channel.

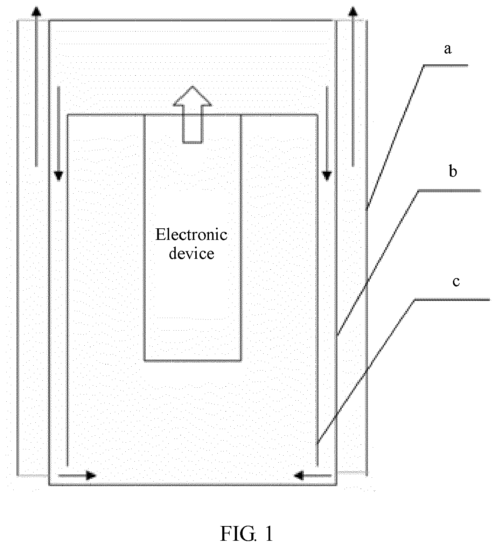

In the prior art, heat may be dissipated for the electronic device inside the cabinet in the following manner. Specifically, as shown in FIG 1, the cabinet includes three layers of side panels, which may be sequentially denoted as a side panel a, a side panel b, and a side panel c in descending order of distances from the electronic device. A gap between the side panel a and the side panel b communicates with the outside of the cabinet to form an external circulation ventilation channel, and a gap between the side panel c and the side panel b communicates with an air intake vent and an air exhaust vent of the electronic device to form an internal circulation ventilation channel. Both the internal circulation ventilation channel and the external circulation ventilation channel transfer heat generated by the electronic device to the outside of the cabinet by using a same side panel (namely, the side panel b).

However, in the prior art, because both the internal circulation ventilation channel and the external circulation ventilation channel transfer the heat generated by the electronic device to the outside of the cabinet by using the same side panel, heat dissipation efficiency is low.

### SUMMARY

This application provides a heat dissipation structure, a cabinet, and a communications system, to resolve a prior-art problem of low heat dissipation efficiency caused because both an internal circulation ventilation channel and an external circulation ventilation channel transfer heat generated by an electronic device to the outside of a cabinet by using a same side panel.

This application provides a heat dissipation structure, configured to dissipate heat for an electronic device mounted inside a cabinet, and including a housing of the cabinet according to claim 1.

A first air vent and a second air vent that have different heights are disposed on the housing, and both the first air vent and the second air vent communicate with the outside of the cabinet.

The housing includes 2N+1 layers of side panels, the 2N+1 layers of side panels include an outer-layer side panel and 2N inner-layer side panels, there is a gap between two neighboring side panels, and the 2N inner-layer side panels are grouped into N groups of inner-layer side panels in an arrangement sequence, where N is a positive integer.

When N is equal to 1, a first gap between a first inner-layer side panel and the outer-layer side panel communicates with the inside of the cabinet, to form an internal circulation ventilation channel.

When N is greater than 1, a first gap between two neighboring inner-layer side panels in different groups and a first gap between the first inner-layer side panel and the outer-layer side panel communicate with each other, and communicate with the inside of the cabinet, to form an internal circulation ventilation channel, and the first inner-layer side panel is an inner-layer side panel that is the farthest from the electronic device in the 2N inner-layer side panels.

Second gaps, each of which is between two inner-layer side panels in a same group, communicate with each other, and communicate with the first air vent and the second air vent, to form an external circulation ventilation channel.

According to the heat dissipation structure provided in the first aspect, when N = 1, a first gap between an inner-layer side panel that is farther from the electronic device in two inner-layer side panels and the outer-layer side panel communicates with the inside of the cabinet, to form an internal circulation ventilation channel; and a second gap between the two inner-layer side panels communicates with the first air vent and the second air vent, and both the first air vent and the second air vent communicate with the outside of the cabinet, to form an external circulation ventilation channel, so that the external circulation ventilation channel is disposed on an inner side of the internal circulation ventilation channel, to additionally increase a heat exchange area when sizes of the side panels of the cabinet are determined. Compared with a heat dissipation structure that is in the prior art and that dissipates heat by using only a heat exchange area provided by an intermediate-layer side panel in three layers of side panels, in the heat dissipation structure provided in this embodiment of this application, all the layers of side panels can provide heat dissipation areas, to improve heat dissipation efficiency.

In addition, when N is greater than 1, the 2N inner-layer side panels are grouped into the N groups of inner-layer side panels in the arrangement sequence, and the first gap between the two neighboring inner-layer side panels in the different groups and the first gap between the first inner-layer side panel and the outer-layer side panel communicate with each other, and communicate with the inside of the cabinet, to form the internal circulation ventilation channel; and the second gap between two inner-layer side panels in one group and the second gap between two inner-layer side panels in another group communicate with each other, and communicate with the first air vent and the second air vent, and both the first air vent and the second air vent communicate with the outside of the cabinet, to form the external circulation ventilation channel, so that when a heat exchange area provided by 2+1 layers of side panels cannot meet a heat dissipation requirement, an even quantity of inner-layer side panels may be added, to further improve a heat dissipation capability.

The heat dissipation structure further includes air blocking panels.

The air blocking panels are disposed between upper ends of two inner-layer side panels forming the second gap and between lower ends of the two inner-layer side panels forming the second gap.

There is a third gap between upper ends of side panels forming the first gap and a top panel of the housing, there is a fourth gap between lower ends of the side panels forming the first gap and a bottom panel of the housing, and both the third gap and the fourth gap communicate with the inside of the cabinet.

According to the heat dissipation structure provided in the first aspect, the air blocking panels are disposed between the upper ends of the two inner-layer side panels forming the second gap and between the lower ends of the two inner-layer side panels forming the second gap, there is the third gap between the upper ends of the side panels forming the first gap and the top panel of the housing, there is the fourth gap between the lower ends of the side panels forming the first gap and the bottom panel of the housing, and both the third gap and the fourth gap communicate with the inside of the cabinet, so that when N is equal to 1, the first gap between the first inner-layer side panel and the outer-layer side panel communicates with the inside of the cabinet, or when N is greater than 1, the first gap between the two neighboring inner-layer side panels in the different groups and the first gap between the first inner-layer side panel and the outer-layer side panel communicate with each other, and communicate with the outside of the cabinet, to form the internal circulation ventilation channel.

According to the invention, both the first air vent and the second air vent are disposed on the outer-layer side panel, and the heat dissipation structure further includes tubular air deflection structures.

A third through hole and a fourth through hole that have different heights are disposed on an inner-layer side panel other than a second inner-layer side panel in the 2N inner-layer side panels, and the second inner-layer side panel is an inner-layer side panel that is the closest to the electronic device in the 2N inner-layer side panels.

When N is equal to 1, the air deflection structure is connected between a third through hole of the first inner-layer side panel and the first air vent, and the air deflection structure is connected between a fourth through hole of the first inner-layer side panel and the second air vent.

When N is greater than 1, the air deflection structure is connected between a third through hole of the first inner-layer side panel and the first air vent, the air deflection structure is connected between a fourth through hole of the first inner-layer side panel and the second air vent, the air deflection structure is connected between third through holes of two neighboring inner-layer side panels in different groups, and the air deflection structure is connected between fourth through holes of the two neighboring inner-layer side panels in the different groups.

According to the heat dissipation structure provided in the first aspect, when N is equal to 1, cold air outside the cabinet may be led into the second gap between the two inner-layer side panels in the same group through the air deflection structure disposed between the fourth through hole of the first inner-layer side panel and the second air vent; and after being heated by the inner-layer side panels, the air is led out through the air deflection structure disposed between the third through hole of the first inner-layer side panel and the first air vent.

According to the heat dissipation structure provided in the first aspect, when N is greater than 1, cold air outside the cabinet may be led into the second gap between the two inner-layer side panels in the same group through the air deflection structure disposed between the fourth through hole of the first inner-layer side panel and the second air vent and the air deflection structure disposed between the fourth through holes of the two neighboring inner-layer side panels in the different groups; and after being heated by the inner-layer side panels, the air is led out through the air deflection structure disposed between the third through hole of the first inner-layer side panel and the first air vent and the air deflection structure disposed between the third through holes of the two neighboring inner-layer side panels in the different groups.

In a possible implementation, the heat dissipation structure further includes a fan disposed in the external circulation ventilation channel.

According to the heat dissipation structure provided in the first aspect, the fan is disposed in the external circulation ventilation channel, so that a flow velocity of air in the external circulation ventilation channel can be greatly increased, and heat dissipation efficiency can be further improved.

In a possible implementation, the side panels include smooth panels or corrugated panels.

In a possible implementation, gilled structures or flow disturbing structures are further disposed on the side panels.

According to the heat dissipation structure provided in the first aspect, the gilled structures or the flow disturbing structures are disposed on the side panels, so that heat dissipation capabilities of the side panels themselves can be improved, and heat dissipation efficiency can be further improved.

According to a second aspect, this application provides a cabinet, including a fan and the heat dissipation structure described in any possible implementation of the first aspect, where the fan is disposed in an internal circulation ventilation channel of the heat dissipation structure.

According to a third aspect, this application provides a communications system, including the cabinet described in the second aspect and an electronic device mounted inside the cabinet.

### BRIEF DESCRIPTION OF DRAWINGS

FIG 1 is a schematic structural diagram of a heat dissipation structure in the prior art;
FIG 2A is a first schematic structural diagram of a heat dissipation structure according to an example not being part of the invention;
FIG 2B is a second schematic structural diagram of a heat dissipation structure according to an example not being part of the invention;
FIG 3A is a main view of a heat dissipation structure according to an example not being part of the invention;
FIG 3B is a top view of the heat dissipation structure according to example not being part of the invention;
FIG 4 is a schematic structural diagram of a heat dissipation structure according to an example not being part of the invention;
FIG 5 is a schematic structural diagram of a heat dissipation structure according to an example not being part of the invention;
FIG 6A is a main view of a heat dissipation structure according to an embodiment of this application;
FIG 6B is a top view of the heat dissipation structure according to an embodiment of this application; and
FIG 7 is a schematic structural diagram of a heat dissipation structure according to another embodiment of this application.

### DETAILED DESCRIPTION OF EMBODIMENTS

Embodiments of this application provide a heat dissipation structure, to dissipate heat for an electronic device mounted inside a cabinet.

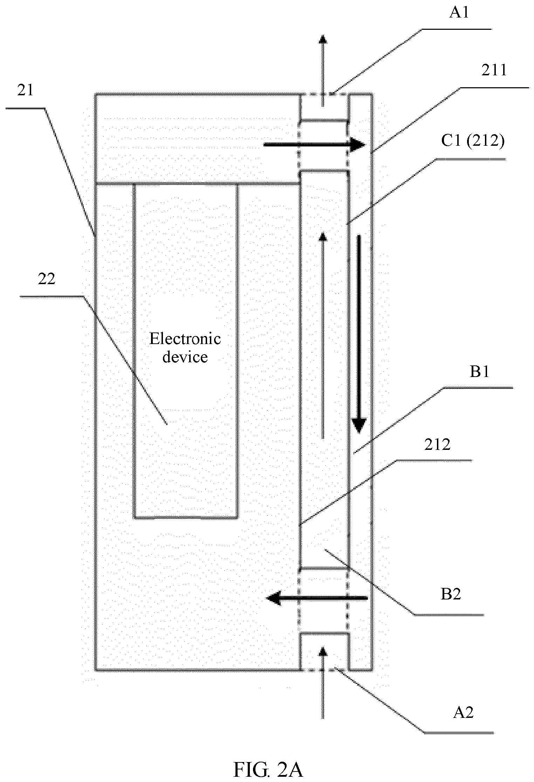

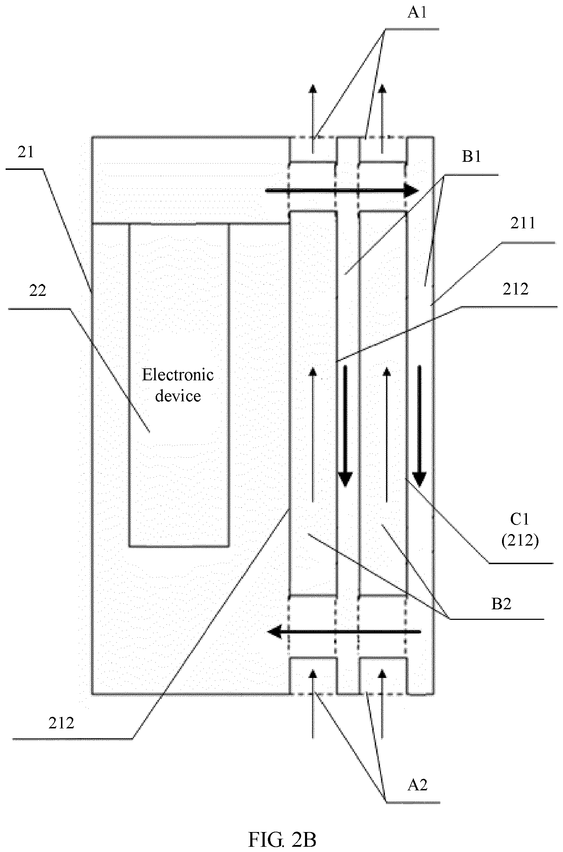

FIG 2A is a first schematic structural diagram of a heat dissipation structure according to an example not being part of the invention, and FIG 2B is a second schematic structural diagram of a heat dissipation structure according to an example not being part of the invention. The heat dissipation structure provided in this example is configured to dissipate heat for an electronic device 22 mounted inside a cabinet 21. As shown in FIG 2A and FIG 2B, the heat dissipation structure in the examples may include a housing of the cabinet 21.

A first air vent A1 and a second air vent A2 that have different heights are disposed on the housing, and both the first air vent A1 and the second air vent A2 communicate with the outside of the cabinet 21.

The housing includes 2N+1 layers of side panels, the 2N+1 layers of side panels include an outer-layer side panel 211 and 2N inner-layer side panels 212, there is a gap between two neighboring side panels, and the 2N inner-layer side panels 212 are grouped into N groups of inner-layer side panels in an arrangement sequence, where N is a positive integer.

When N is equal to 1, a first gap B1 between a first inner-layer side panel C1 and the outer-layer side panel 211 communicates with the inside of the cabinet 21, to form an internal circulation ventilation channel.

When N is greater than 1, a first gap B1 between two neighboring inner-layer side panels 212 in different groups and a first gap B1 between a first inner-layer side panel C1 and the outer-layer side panel 211 communicate with each other, and communicate with the inside of the cabinet 21, to form an internal circulation ventilation channel, and the first inner-layer side panel C1 is an inner-layer side panel that is the farthest from the electronic device 22 in the 2N inner-layer side panels 212.

A second gap B2 between two inner-layer side panels 212 in one group and a second gap B2 between two inner-layer side panels 212 in another group communicate with each other, and communicate with the first air vent A1 and the second air vent A2, to form an external circulation ventilation channel.

It should be noted that FIG 2A uses a scenario of N = 1 as an example and FIG 2B uses a scenario of N = 2 as an example. In this example, a wind direction in the internal circulation ventilation channel may be specifically shown by thick arrows in FIG 2A and FIG 2B, and a wind direction in the external circulation ventilation channel may be specifically shown by thin arrows in FIG 2A and FIG 2B.

It should be noted that the wind direction in the external circulation ventilation channel may be from bottom to top or from top to bottom, and the wind direction in the internal circulation ventilation channel may be a clockwise direction or a counter-clockwise direction. The wind direction in the external circulation ventilation channel and the wind direction in the internal circulation ventilation channel are not specifically limited in this example. For example, when the external circulation ventilation channel relies on a chimney effect, the wind direction in the external circulation ventilation channel is from bottom to top. Alternatively, when a fan blowing air from top to bottom is added in the external circulation ventilation channel, the wind direction in the external circulation ventilation channel is from top to bottom.

It should be noted that a specific implementation in which the first gap B1 between the two neighboring inner-layer side panels 212 in the different groups communicates with the first gap B1 between the first inner-layer side panel C1 and the outer-layer side panel 211 and a specific implementation in which the second gap B2 between the two inner-layer side panels 212 in one group communicates with the second gap B2 between the two inner-layer side panels 212 in another group are not limited in this example. For example, a plurality of gaps may communicate with each other through another gap, or a plurality of first gaps may communicate with each other through an air deflection structure.

It should be noted that a specific manner in which the first gap B 1 communicates with the inside of the cabinet to form the internal circulation ventilation channel is not limited in this example. For example, as shown in FIG 2A and FIG. 2B, a through hole may be disposed on a panel that is inside the cabinet and that is connected to the electronic device 22, to form the internal circulation ventilation channel. A fan may be disposed between the panel and a top panel of cabinet, to drive air in the internal circulation ventilation channel to flow.

That the height of the first air vent A1 is greater than the height of the second air vent A2 is used as an example. Optionally, the first air vent A1 may be disposed on a top panel of the housing, and the second air vent A2 may be disposed on a bottom panel and/or the outer-layer side panel 211 of the housing. Alternatively, the first air vent A1 may be disposed on the outer-layer side panel 211 of the housing, and the second air vent A2 may be disposed on a bottom panel and/or the outer-layer side panel 211 of the housing.

As shown in FIG 2A, that N is equal to 1, and the external circulation ventilation channel relies on the chimney effect is used as an example. A heat exchange principle of the heat dissipation structure provided in this example may be specifically as follows:

When hot air in the cabinet 21 reaches the first gap B1 between the first inner-layer side panel C1 and the outer-layer side panel 211, heat may be transferred to the first inner-layer side panel C1 and the outer-layer side panel 211 through convective heat exchange, the outer-layer side panel 211 may directly perform convective heat exchange and radiation heat exchange with outside air, and the first inner-layer side panel C1 may perform convective heat exchange with air in the external circulation ventilation channel. An inner-layer side panel 212 other than the first inner-layer side panel C1 may be in direct contact with the hot air in the cabinet, is directly heated, and then performs convective heat exchange with the air in the external circulation ventilation channel. The air in the external circulation ventilation channel is heated by the inner-layer side panel 212, to form the chimney effect, to drive the hot air in the external circulation ventilation channel to flow out from a relatively high air exhaust vent, and cold air constantly flows in from a relatively low air intake vent, to constantly bring away heat in the cabinet, to implement heat dissipation.

It can be learned from the foregoing heat exchange principle that when N is equal to 1, the heat dissipation structure provided in this example can dissipate heat by using all the three layers of side panels included in the housing.

In this example, when a heat exchange area provided by the 2+1 layers of side panels cannot meet a heat dissipation requirement, an even quantity of inner-layer side panels may be added, that is, N may be increased, to further improve a heat dissipation capability.

As shown in FIG 2B, that N is equal to 2, and the external circulation ventilation channel relies on the chimney effect is used as an example. A heat exchange principle of the heat dissipation structure in this example may be specifically as follows:

When hot air in the cabinet 21 reaches the first gap B1 between the first inner-layer side panel C1 and the outer-layer side panel 211, heat may be transferred to the first inner-layer side panel C1 and the outer-layer side panel 211 through convective heat exchange, the outer-layer side panel 211 may directly perform convective heat exchange and radiation heat exchange with outside air, and the first inner-layer side panel C1 may perform convective heat exchange with air in the external circulation ventilation channel. When the hot air in the cabinet 21 reaches the first gap B1 between the two neighboring inner-layer side panels 212 in the different groups, heat may be transferred to the two neighboring inner-layer side panels 212 in the different groups through convective heat exchange, and the two neighboring inner-layer side panels 212 in the different groups may perform convective heat exchange with the air in the external circulation ventilation channel. An inner-layer side panel that is the closest to the electronic device 22 may be in direct contact with the hot air in the cabinet, is directly heated, and performs convective heat exchange with the air in the external circulation ventilation channel. The air in the external circulation ventilation channel is heated by the inner-layer side panel 212, to form the chimney effect, to drive the hot air in the external circulation ventilation channel to flow out from a relatively high air exhaust vent, and cold air constantly flows in from a relatively low air intake vent, to constantly bring away heat in the cabinet, to implement heat dissipation.

It can be learned from the foregoing heat exchange principle that when N is greater than 1, the heat dissipation structure provided in this example can dissipate heat by using all the 2N+1 layers of side panels included in the housing.

In this example, when N = 1, a first gap between an inner-layer side panel that is farther from the electronic device in two inner-layer side panels and the outer-layer side panel communicates with the inside of the cabinet, to form an internal circulation ventilation channel; and a second gap between the two inner-layer side panels communicates with the first air vent and the second air vent, and both the first air vent and the second air vent communicate with the outside of the cabinet, to form an external circulation ventilation channel, so that the external circulation ventilation channel is disposed on an inner side of the internal circulation ventilation channel, to additionally increase a heat exchange area when sizes of side panels of the cabinet are determined. Compared with the heat dissipation structure that is shown in FIG 1 and that dissipates heat by using only a heat exchange area provided by an intermediate-layer side panel in three layers of side panels, in the heat dissipation structure provided in this example, all the layers of side panels can provide heat dissipation areas, to improve heat dissipation efficiency.

In addition, when N is greater than 1, the 2N inner-layer side panels are grouped into the N groups of inner-layer side panels in the arrangement sequence, and the first gap between the two neighboring inner-layer side panels in the different groups and the first gap between the first inner-layer side panel and the outer-layer side panel communicate with each other, and communicate with the inside of the cabinet, to form the internal circulation ventilation channel; and the second gap between two inner-layer side panels in one group and the second gap between two inner-layer side panels in another group communicate with each other, and communicate with the first air vent and the second air vent, and both the first air vent and the second air vent communicate with the outside of the cabinet, to form the external circulation ventilation channel, so that when a heat exchange area provided by 2+1 layers of side panels cannot meet a heat dissipation requirement, an even quantity of inner-layer side panels may be added, to further improve a heat dissipation capability.

In addition, because the heat dissipation structure provided in this example can improve heat dissipation efficiency without using an extra heat exchange component, the heat dissipation structure provided in this example can reduce costs. Further, because the heat dissipation structure provided in this example can improve heat dissipation efficiency without changing the sizes of the side panels of the cabinet, the heat dissipation structure provided in this example can ensure consistency of appearance of the cabinet.

It should be noted that side panels on any one or more sides of the housing of the cabinet can use the heat dissipation structure provided in this example.

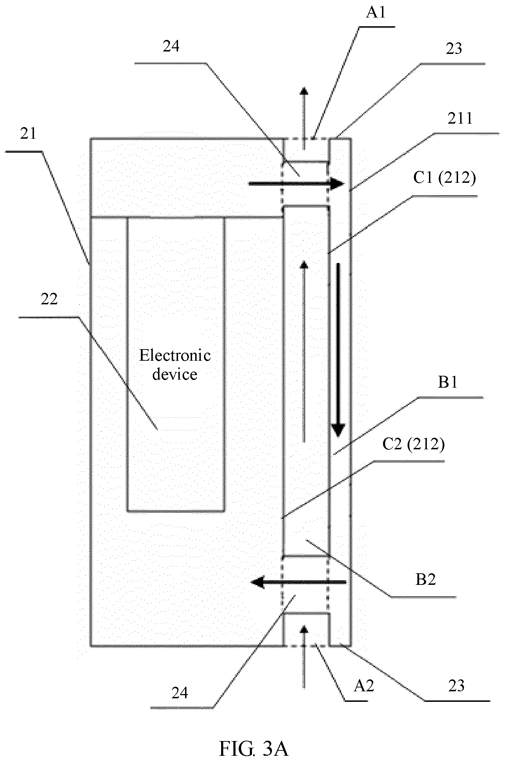

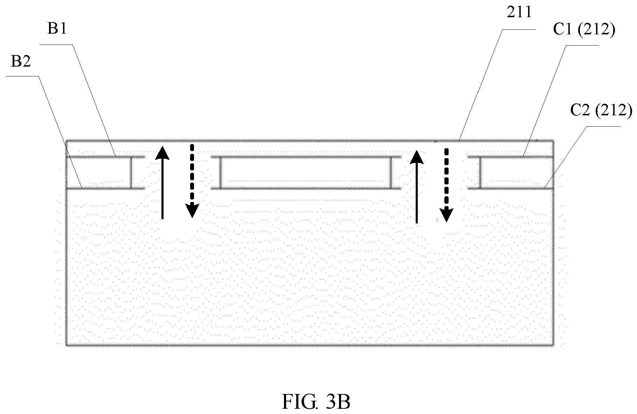

FIG 3A is a main view of a heat dissipation structure according to another example not being part of the invention , and FIG 3B is a top view of the heat dissipation structure according to the example. This examplemainly describes an optional implementation of forming the internal circulation ventilation channel based on the examples shown in FIG 2A and FIG 2B. As shown in FIG. 3A and FIG 3B, the heat dissipation structure in this example may further include air blocking panels 23 and tubular air deflection structures 24.

The air blocking panels 23 are disposed between upper ends of two side panels forming the first gap B1 and between lower ends of the two side panels forming the first gap B1.

A first through hole (not shown) and a second through hole (not shown) that have different heights are disposed on each inner-layer side panel 212, and a first through hole and a fourth through hole that are disposed on a second inner-layer side panel C2 separately communicate with the inside of the cabinet 21. The second inner-layer side panel C2 is an inner-layer side panel that is the closest to the electronic device 22 in the 2N inner-layer side panels.

The air deflection structure 24 is connected between first through holes of two inner-layer side panels in a same group, and the air deflection structure 24 is connected between second through holes of the two inner-layer side panels in the same group.

It should be noted that one or more first through holes and one or more second through holes may be disposed on a same inner-layer side panel. A same quantity of first through holes and a same quantity of second through holes may be disposed on two inner-layer side panels in a same group. Heights of first through holes disposed on different inner-layer side panels may be the same or may be different, heights of second through holes disposed on different inner-layer side panels may be the same or may be different, and this is not limited in this example.

It should be noted that the two side panels forming the first gap B1 may be the first inner-layer side panel C1 and the outer-layer side panel 211, or may be two neighboring inner-layer side panels 212 in different groups.

It should be noted that FIG 3A uses an example in which the first air vent A1 is disposed on the top panel of the housing, the second air vent A2 is disposed on the bottom panel of the housing, and N is equal to 1. Thick solid arrows in FIG 3B may represent a direction of air entering the first gap B1 in the internal circulation ventilation channel, and thick dashed arrows may represent a direction of air exiting from the first gap B1 in the internal circulation ventilation channel. FIG 3B uses an example in which two first through holes and two second through holes are disposed on a same inner-layer side panel.

As shown in FIG 3A and FIG 3B, when N is equal to 1, hot air in the cabinet 21 is led into the first gap B1 between the first inner-layer side panel C1 and the outer-layer side panel 211 through an air deflection structure disposed between upper ends of two inner-layer side panels; and after being cooled through heat exchange, the air is led back into the cabinet 21 through an air deflection structure disposed between lower ends of the two inner-layer side panels.

Optionally, the air deflection structure 24 may be specifically an air deflection twyer. A shape of a cross-section of the air deflection twyer includes but is not limited to a rectangle, a round, an ellipse, a triangle, a polygon, and the like, or is a combination of the foregoing shapes.

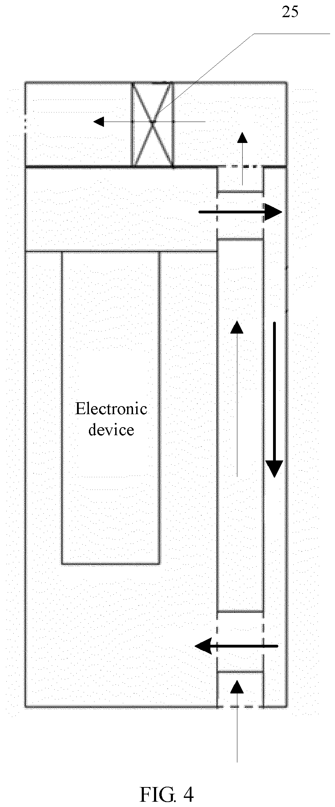

Optionally, as shown in FIG 4, the heat dissipation structure in this example may further include a fan 25 disposed in the external circulation ventilation channel. In this example, the fan is disposed in the external circulation ventilation channel, so that a flow velocity of air in the external circulation ventilation channel can be greatly increased, and heat dissipation efficiency can be further improved.

It should be noted that FIG 4 uses an example in which the fan 25 is disposed on a top part of the cabinet, and a location of disposing the fan 25 is not limited in this example. For example, the fan 25 may alternatively be disposed on a bottom part of the cabinet.

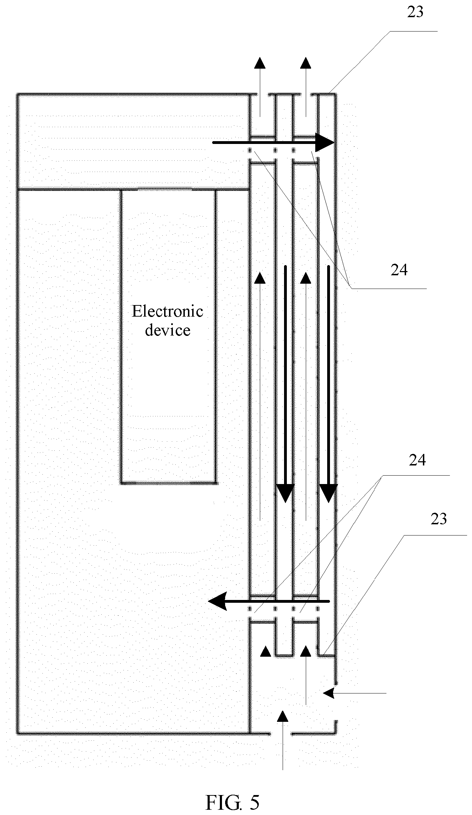

It should be noted that FIG 3A and FIG 3B use an example in which the air blocking panel 23 disposed between the upper ends of the two side panels forming the first gap B1 is the top panel of the housing, and the air blocking panel 23 disposed between the lower ends of the two side panels forming the first gap B1 is the bottom panel of the housing. The air blocking panel 23 may alternatively be a panel, other than the top panel and the bottom panel of the housing, disposed and specially used to form a closed internal circulation ventilation channel. For example, as shown in FIG 5, the air blocking panel 23 disposed between the lower ends of the two side panels forming the first gap B1 may be a panel, other than the top panel and the bottom panel of the housing, disposed and specially used to form a closed internal circulation ventilation channel. A person skilled in the art may understand that the air blocking panel 23 disposed between the upper ends of the two side panels forming the first gap B1 may alternatively be a panel, other than the top panel and the bottom panel of the housing, disposed and specially used to form a closed internal circulation ventilation channel.

It should be noted that FIG 5 uses an example in which the first air vent A1 is disposed on the top panel of the housing, the second air vent A2 is disposed on the bottom panel and the outer-layer side panel 211 of the housing, and N is equal to 2.

As shown in FIG 5, when N is equal to 2, hot air in the cabinet 21 is led into the first gap B1 between the first inner-layer side panel C1 and the outer-layer side panel 211 and the first gap B1 between the two inner-layer side panels in the different groups through the air deflection structure disposed between the first through holes of the two inner-layer side panels in the same group; and after being cooled through heat exchange, the air is led back into the inside of the cabinet 21 through the air deflection structure disposed between the second through holes of the two inner-layer side panels in the same group.

As shown in FIG 3A to FIG 5, a quantity of air deflection structures 24 in this example is at least 2N. A specific quantity of air deflection structures 24 is not limited in this example, and the quantity of air deflection structures may be flexibly set provided that at least one air deflection structure is used to lead the hot air into the cabinet 21 to the first gap and at least one air deflection structure is used to lead the cold air that is cooled through heat exchange back into the inside of the cabinet 21.

In this example, the air blocking panels are disposed between the upper ends of the two side panels forming the first gap and between the lower ends of the two side panels forming the first gap, the first through hole and the second through hole that have different heights are disposed on each inner-layer side panel, and both the first through hole and the second through hole disposed on the second inner-layer side panel communicate with the inside of the cabinet. The second inner-layer side panel is an inner-layer side panel that is the closest to the electronic device in the 2N inner-layer side panels, the air deflection structure is connected between the first through holes of the two inner-layer side panels in the same group, and the air deflection structure is connected between the second through holes of the two inner-layer side panels in the same group, so that the first gap between the two neighboring inner-layer side panels in the different groups and the first gap between the first inner-layer side panel and the outer-layer side panel communicate with each other, and communicate with a third air vent and a fourth air vent, to form the internal circulation ventilation channel.

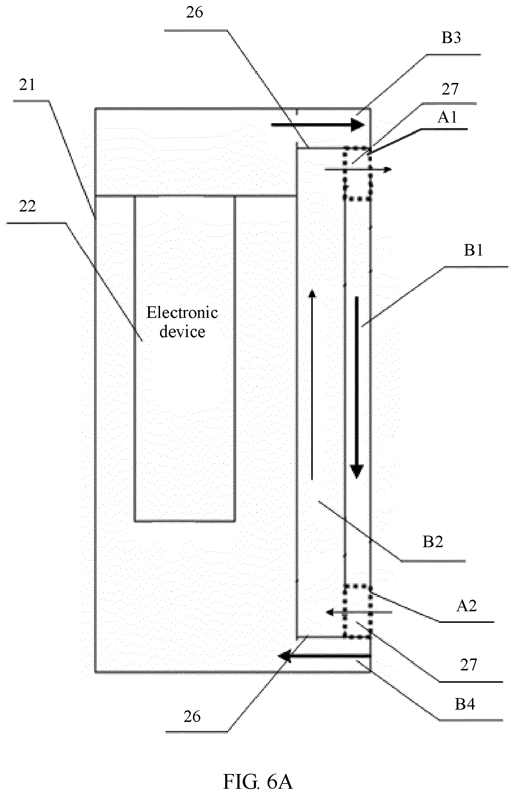

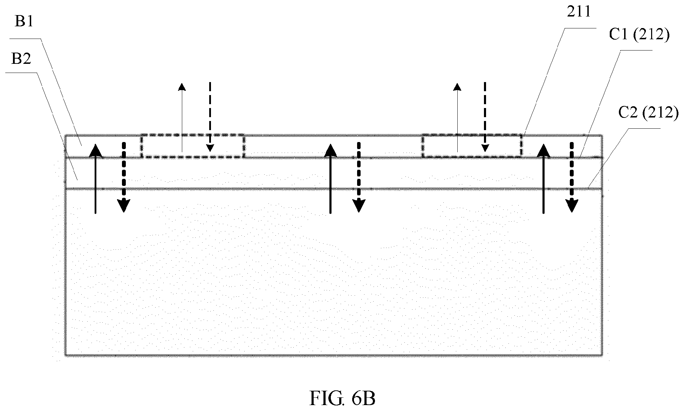

FIG 6A is a main view of a heat dissipation structure according to an embodiment of this application, and FIG 6B is a top view of the heat dissipation structure according to the embodiment of this application. This embodiment mainly describes another implementation of forming the internal circulation ventilation channel based on the examples shown in FIG 2A and FIG 2B. As shown in FIG 6A and FIG 6B, the heat dissipation structure in this embodiment further includes air blocking panels 26.

The air blocking panels 26 are disposed between upper ends of two inner-layer side panels 212 forming the second gap B2 and between lower ends of the two inner-layer side panels forming the second gap B2.

There is a third gap B3 between upper ends of side panels forming a first gap B1 and a top panel of the housing, there is a fourth gap B4 between lower ends of the side panels forming the first gap B1 and a bottom panel of the housing, and both the third gap B3 and the fourth gap B4 communicate with the inside of the cabinet 21.

It should be noted that the two side panels forming the second gap B2 are specifically two inner-layer side panels 212 in a same group. FIG. 6Aand FIG 6B use an example in which N is equal to 1. Thick solid arrows in FIG. 6B may represent a direction of air entering the first gap B1 in the internal circulation ventilation channel, and thick dashed arrows may represent a direction of air exiting from the first gap B1 in the internal circulation ventilation channel.

As shown in FIG 6A and FIG 6B, when N is equal to 1, hot air in the cabinet 21 enters the first gap B1 between the first inner-layer side panel C1 and the outer-layer side panel 211 through the third gap B3 between the upper ends of the side panels forming the first gap B1 and the top panel of the housing; and after being cooled through heat exchange, the air is led back into the inside of the cabinet 21 through the fourth gap B4 between the lower ends of the side panels forming the first gap B1 and the bottom panel of the housing.

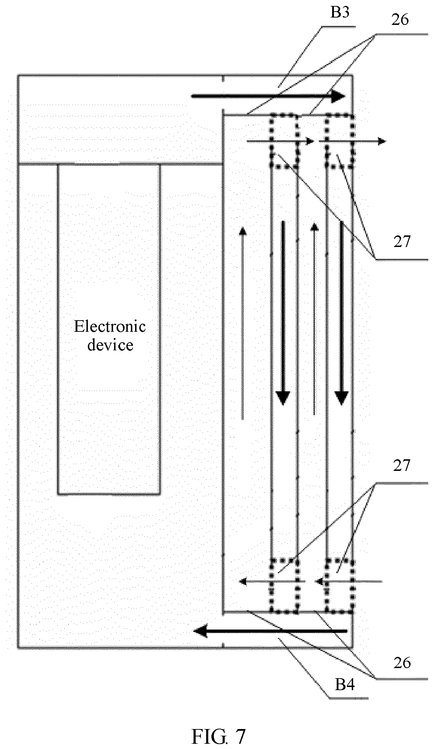

In this embodiment, when N is equal to 2, a schematic structural diagram of the heat dissipation structure may be shown in FIG 7.

As shown in FIG 6A to FIG 7, both the first air vent A1 and the second air vent A2 are disposed on the outer-layer side panel 211. The heat dissipation structure further includes tubular air deflection structures 27.

A third through hole (not shown) and a fourth through hole (not shown) that have different heights are disposed on an inner-layer side panel other than a second inner-layer side panel C2 in the 2N inner-layer side panels 212, and the second inner-layer side panel C2 is an inner-layer side panel that is the closest to the electronic device 22 in the 2N inner-layer side panels.

It should be noted that one or more third through holes and one or more fourth through holes are disposed on a same inner-layer side panel. A same quantity of third through holes and a same quantity of fourth through holes may be disposed on two inner-layer side panels in a same group. Heights of third through holes disposed on different inner-layer side panels may be the same or may be different, heights of fourth through holes disposed on different inner-layer side panels may be the same or may be different, and this is not limited in this embodiment of this application. Heights of a third through hole disposed on the first inner-layer side panel and the first air vent A1 may be the same or may be different, and this is not limited in this embodiment of this application. Heights of a fourth through hole disposed on the first inner-layer side panel and the second air vent A2 may be the same or may be different, and this is not limited in this embodiment of this application.

It should be noted that thin solid arrows in FIG 6B may represent a direction of air exiting from the second gap B2 in the external circulation ventilation channel, and thin dashed arrows may represent a direction of air entering the second gap B2 in the external circulation ventilation channel. FIG 6B uses an example in which two third through holes and two fourth through holes are disposed on a same inner-layer side panel.

As shown in FIG 6A and FIG 6B, when N is equal to 1, the air deflection structure 27 is connected between the third through hole of the first inner-layer side panel C1 and the first air vent A1, and the air deflection structure 27 is connected between the fourth through hole of the first inner-layer side panel C1 and the second air vent A2.

Specifically, as shown in FIG 6A and FIG 6B, when N is equal to 1, cold air outside the cabinet may be led into the second gap B2 between the two inner-layer side panels in the same group through the air deflection structure 27 disposed between the fourth through hole of the first inner-layer side panel C1 and the second air vent A2; and after being heated by the inner-layer side panels, the air is led out through the air deflection structure 27 disposed between the third through hole of the first inner-layer side panel C1 and the first air vent A1.

As shown in FIG 7, when N is greater than 1, the air deflection structure 27 is connected between the third through hole of the first inner-layer side panel C1 and the first air vent A1, the air deflection structure 27 is connected between the fourth through hole of the first inner-layer side panel C1 and the second air vent A2, the air deflection structure 27 is connected between third through holes of two neighboring inner-layer side panels in different groups, and the air deflection structure 27 is connected between fourth through holes of the two neighboring inner-layer side panels in the different groups.

Specifically, as shown in FIG 7, when N is greater than 1, cold air outside the cabinet may be led into the second gap B2 between the two inner-layer side panels in the same group through the air deflection structure 27 disposed between the fourth through hole of the first inner-layer side panel C1 and the second air vent A2 and the air deflection structure 27 disposed between the fourth through holes of the two neighboring inner-layer side panels in the different groups; and after being heated by the inner-layer side panels, the air is led out through the air deflection structure 27 disposed between the third through hole of the first inner-layer side panel C1 and the first air vent A1 and the air deflection structure 27 disposed between the third through holes of the two neighboring inner-layer side panels in the different groups.

Optionally, the air deflection structure 27 may be specifically an air deflection twyer. A shape of a cross-section of the air deflection twyer includes but is not limited to a rectangle, a round, an ellipse, a triangle, a polygon, and the like, or is a combination of the foregoing shapes.

Optionally, the heat dissipation structure in this embodiment may further include a fan (not shown) disposed in the external circulation ventilation channel. In this embodiment, the fan is disposed in the external circulation ventilation channel, so that a flow velocity of air in the external circulation ventilation channel can be greatly increased, and heat dissipation efficiency can be further improved. A location of disposing the fan is not limited in this embodiment. For example, the fan may be disposed on a top part or a bottom part of the cabinet 21.

As shown in FIG 6A to FIG 7, a quantity of air deflection structures 27 in this embodiment is at least 2N. A specific quantity of air deflection structures 27 is not limited in this embodiment, and the quantity of air deflection structures may be flexibly set provided that at least one air deflection structure is used to lead the cold air outside the cabinet 21 into the second gap and at least one air deflection structure is used to lead the hot air that is heated through heat exchange out to the outside of the cabinet 21.

In this embodiment, the air blocking panels are disposed between the upper ends of the two inner-layer side panels forming the second gap and between the lower ends of the two inner-layer side panels forming the second gap, there is the third gap between the upper ends of the side panels forming the first gap and the top panel of the housing, there is the fourth gap between the lower ends of the side panels forming the first gap and the bottom panel of the housing, and both the third gap and the fourth gap communicate with the inside of the cabinet, so that the first gap between the two neighboring inner-layer side panels in the different groups and the first gap between the first inner-layer side panel and the outer-layer side panel communicate with each other, and communicate with the inside of the cabinet, to form the internal circulation ventilation channel.

Optionally, in the foregoing embodiments of this application, the side panels may include smooth panels, corrugated panels, or the like. Herein, the side panel may be specifically the inner-layer side panel or the outer-layer side panel.

Optionally, in the foregoing embodiments of this application, gilled structures or flow disturbing structures may be further disposed on the side panels. The gilled structures or the flow disturbing structures are further disposed on the side panels, so that heat dissipation capabilities of the side panels themselves can be improved, and heat dissipation efficiency can be further improved.

It should be noted that specific forms of the gilled structures or the flow disturbing structures are not limited in this embodiment of this application. For example, the gilled structures or the flow disturbing structures may be triangular winglets, rectangular wings, semi-ellipse wings, or the like, or a combination of several of the foregoing structure forms.

An embodiment of this application further provides a cabinet. The cabinet includes a fan and the heat dissipation structure described in any one of the foregoing embodiments, and the fan is disposed in an internal circulation ventilation channel of the heat dissipation structure.

In this embodiment of this application, when N = 1, a first gap between an inner-layer side panel that is farther from an electronic device in two inner-layer side panels and an outer-layer side panel communicates with the inside of the cabinet, to form the internal circulation ventilation channel; and a second gap between the two inner-layer side panels communicates with a first air vent and a second air vent, and both the first air vent and the second air vent communicate with the outside of the cabinet, to form an external circulation ventilation channel, so that the external circulation ventilation channel is disposed on an inner side of the internal circulation ventilation channel, to additionally increase a heat exchange area when a size of the cabinet is determined. Compared with the heat dissipation structure that is shown in FIG 1 and that dissipates heat by using only a heat exchange area provided by an intermediate-layer side panel in three layers of side panels, in the cabinet provided in this embodiment of this application, all layers of side panels can provide heat dissipation areas, to improve heat dissipation efficiency of the cabinet.

In addition, when N is greater than 1, 2N inner-layer side panels are grouped into N groups of inner-layer side panels in an arrangement sequence, a first gap between two neighboring inner-layer side panels in different groups and a first gap between a first inner-layer side panel and an outer-layer side panel communicate with each other, and communicate with the inside of the cabinet, to form the internal circulation ventilation channel; and second gaps, each of which is between two inner-layer side panels in a same group, communicate with each other, and communicate with a first air vent and a second air vent, and both the first air vent and the second air vent communicate with the outside of the cabinet, to form an external circulation ventilation channel, so that when a heat exchange area provided by 2+1 layers of side panels cannot meet a heat dissipation requirement, an even quantity of inner-layer side panels may be added, to further improve a heat dissipation capability of the cabinet.

In addition, because the cabinet provided in this embodiment of this application can improve heat dissipation efficiency without using an extra heat exchange component, the cabinet provided in this embodiment of this application can reduce costs. Further, because the cabinet provided in this embodiment of this application can improve heat dissipation efficiency without changing sizes of side panels of the cabinet, the cabinet provided in this embodiment of this application can ensure consistency of appearance of the cabinet.

An embodiment of this application further provides a communications system. The communications system includes the cabinet described in the foregoing embodiments and an electronic device mounted inside the cabinet.

## Claims

1. A heat dissipation structure, configured to dissipate heat for an electronic device (22) mounted inside a cabinet (21), and comprising a housing of the cabinet (21), wherein
a first air vent (A1) and a second air vent (A2) that have different heights are disposed on the housing, and both the first air vent (A1) and the second air vent (A2) communicate with the outside of the cabinet (21);
the housing comprises 2N+1 layers of side panels, the 2N+1 layers of side panels comprise an outer-layer side panel (211) and 2N inner-layer side panels, there is a gap between two neighboring side panels, and the 2N inner-layer side panels are grouped into N groups of inner-layer side panels in an arrangement sequence, wherein N is a positive integer;
when N is equal to 1, a first gap (B1) between a first inner-layer side panel and the outer-layer side panel (211) communicates with the inside of the cabinet (21), to form an internal circulation ventilation channel; or
when N is greater than 1, a first gap (B1) between two neighboring inner-layer side panels in different groups and a first gap (B1) between the first inner-layer side panel and the outer-layer side panel (211) communicate with each other, and communicate with the inside of the cabinet (21), to form an internal circulation ventilation channel, and the first inner-layer side panel is an inner-layer side panel that is the farthest from the electronic device (22) in the 2N inner-layer side panels; and
when N is equal to 1, a second gap (B2) between the two inner-layer side panels communicates with the first air vent (A1) and the second air vent (A2), to form an external circulation ventilation channel;
and when N is greater than 1,
second gaps (B2), each of which is between two inner-layer side panels in a same group communicate with each other, and communicate with the first air vent (A1) and the second air vent (A2), to form an external circulation ventilation channel;
and wherein
the heat dissipation structure further comprises air blocking panels (26);
the air blocking panels (26) are disposed between upper ends of two inner-layer side panels forming the second gap (B2) and between lower ends of the two inner-layer side panels forming the second gap (B2); and
there is a third gap (B3) between upper ends of side panels forming the first gap (B1) and a top panel of the housing, there is a fourth gap (B4) between lower ends of the side panels forming the first gap (B1) and a bottom panel of the housing, and both the third gap (B3) and the fourth gap (B4) communicate with the inside of the cabinet (21); and
**characterized in that**
both the first air vent (A1) and the second air vent (A2) are disposed on the outer-layer side panel (211), and the heat dissipation structure further comprises tubular air deflection structures (27);
a third through hole and a fourth through hole that have different heights are disposed on an inner-layer side panel other than a second inner-layer side panel in the 2N inner-layer side panels, and the second inner-layer side panel is an inner-layer side panel that is the closest to the electronic device (22) in the 2N inner-layer side panels; and
when N is equal to 1, one of the air deflection structures (27) is connected between a third through hole of the first inner-layer side panel and the first air vent (A1), and another one of the air deflection structures (27) is connected between a fourth through hole of the first inner-layer side panel and the second air vent (A2); or
when N is greater than 1, one of the air deflection structures (27) is connected between a third through hole of the first inner-layer side panel and the first air vent (A1), another one of the air deflection structures (27) is connected between a fourth through hole of the first inner-layer side panel and the second air vent (A2), another one of the air deflection structures (27) is connected between third through holes of two neighboring inner-layer side panels in different groups, and another one of the air deflection structures (27) is connected between fourth through holes of the two neighboring inner-layer side panels in the different groups.

2. The heat dissipation structure according to claim 1, wherein the heat dissipation structure further comprises a fan disposed in the external circulation ventilation channel.

3. The heat dissipation structure according to claim 1, wherein the side panels comprise smooth panels or corrugated panels.

4. The heat dissipation structure according to claim 3, wherein gilled structures or flow disturbing structures are further disposed on the side panels.

5. A cabinet (21), comprising a fan and the heat dissipation structure according to any one of claims 1 to 4, wherein the fan is disposed in an internal circulation ventilation channel of the heat dissipation structure.

6. A communications system, comprising the cabinet (21) according to claim 5 and an electronic device (22) mounted inside the cabinet (21).

## Patentansprüche

1. Wärmeableitungsstruktur, die konfiguriert ist, um Wärme für eine elektronische Vorrichtung (22), die innerhalb eines Schranks (21) montiert ist, abzuleiten und umfassend ein Gehäuse des Schranks (21), wobei
eine erste Entlüftungsöffnung (A1) und eine zweite Entlüftungsöffnung (A2), die unterschiedliche Höhen aufweisen, an dem Gehäuse eingerichtet sind und sowohl die erste Entlüftungsöffnung (A1) als auch die zweite Entlüftungsöffnung (A2) mit der Außenseite des Schranks (21) kommunizieren;
das Gehäuse 2N+1 Schichten von Seitenwänden umfasst, wobei die 2N+1 Schichten von Seitenwänden eine Außenschichtseitenwand (211) und 2N Innenschichtseitenwände umfassen, sich ein Spalt zwischen zwei benachbarten Seitenwänden befindet und die 2N Innenschichtseitenwände in einer Anordnungsreihenfolge in N Gruppen von Innenschichtseitenwänden gruppiert sind, wobei N eine positive ganze Zahl ist;
wenn N gleich 1 ist, ein erster Spalt (B1) zwischen einer ersten Innenschichtseitenwand und der Außenschichtseitenwand (211) mit der Innenseite des Schranks (21) kommuniziert, um einen internen Zirkulationslüftungskanal auszubilden; oder
wenn N größer als 1 ist, ein erster Spalt (B1) zwischen zwei benachbarten Innenschichtseitenwänden in unterschiedlichen Gruppen und ein erster Spalt (B1) zwischen der ersten Innenschichtseitenwand und der Außenschichtseitenwand (211) miteinander kommunizieren und mit der Innenseite des Schranks (21) kommunizieren, um einen internen Zirkulationslüftungskanal auszubilden und wobei die erste Innenschichtseitenwand eine Innenschichtseitenwand ist, die von der elektronischen Vorrichtung (22) in den 2N Innenschichtseitenwänden am weitesten entfernt ist; und
wenn N gleich 1 ist, ein zweiter Spalt (B2) zwischen den zwei Innenschichtseitenwänden mit der ersten Entlüftungsöffnung (A1) und der zweiten Entlüftungsöffnung (A2) kommuniziert, um einen externen Zirkulationslüftungskanal auszubilden; und wenn N größer als 1 ist, zweite Spalten (B2), die sich jeweils zwischen zwei Innenschichtseitenwänden in einer gleichen Gruppe befinden, miteinander kommunizieren und mit der ersten Entlüftungsöffnung (A1) und der zweiten Entlüftungsöffnung (A2) kommunizieren, um einen externen Zirkulationslüftungskanal auszubilden; und wobei
die Wärmeableitungsstruktur ferner Luftblockierwände (26) umfasst;
die Luftblockierwände (26) zwischen oberen Enden von zwei Innenschichtseitenwänden, die den zweiten Spalt (B2) ausbilden, und zwischen unteren Enden der zwei Innenschichtseitenwänden, die den zweiten Spalt (B2) ausbilden, eingerichtet sind; und
sich ein dritter Spalt (B3) zwischen oberen Enden der Seitenwände, die den ersten Spalt (B1) ausbilden, und einer oberen Wand des Gehäuses befindet, sich ein vierter Spalt (B4) zwischen unteren Enden der Seitenwände, die den ersten Spalt (B1) ausbilden, und einer Bodenwand des Gehäuses befindet und sowohl der dritte Spalt (B3) als auch der vierte Spalt (B4) mit der Innenseite des Schranks (21) kommunizieren; und
**dadurch gekennzeichnet, dass**
sowohl die erste Entlüftungsöffnung (A1) als auch die zweite Entlüftungsöffnung (A2) an der Außenschichtseitenwand (211) eingerichtet sind und die Wärmeableitungsstruktur ferner rohrförmige Luftablenkungsstrukturen (27) umfasst;
ein drittes Durchgangsloch und ein viertes Durchgangsloch, die unterschiedliche Höhen aufweisen, an einer Innenschichtseitenwand außer einer zweiten Innenschichtseitenwand in den 2N Innenschichtseitenwänden eingerichtet sind und wobei die zweite Innenschichtseitenwand eine Innenschichtseitenwand ist, die zu der elektronischen Vorrichtung (22) in den 2N Innenschichtseitenwänden am nächsten ist; und
wenn N gleich 1 ist, eine der Luftablenkungsstrukturen (27) zwischen einem dritten Durchgangsloch der ersten Innenschichtseitenwand und der ersten Entlüftungsöffnung (A1) verbunden ist und eine andere der Luftablenkungsstrukturen (27) zwischen einem vierten Durchgangsloch der ersten Innenschichtseitenwand und der zweiten Entlüftungsöffnung (A2) verbunden ist; oder
wenn N größer als 1 ist, eine der Luftablenkungsstrukturen (27) zwischen einem dritten Durchgangsloch der ersten Innenschichtseitenwand und der ersten Entlüftungsöffnung (A1) verbunden ist, eine andere der Luftablenkungsstrukturen (27) zwischen einem vierten Durchgangsloch der ersten Innenschichtseitenwand und der zweiten Entlüftungsöffnung (A2) verbunden ist, eine andere der Luftablenkungsstrukturen (27) zwischen dritten Durchgangslöchern von zwei benachbarten Innenschichtseitenwänden in unterschiedlichen Gruppen verbunden ist und eine andere der Luftablenkungsstrukturen (27) zwischen vierten Durchgangslöchern der zwei benachbarten Innenschichtseitenwände in den unterschiedlichen Gruppen verbunden ist.

2. Wärmeableitungsstruktur nach Anspruch 1, wobei die Wärmeableitungsstruktur ferner einen Ventilator, der in dem externen Zirkulationslüftungskanal eingerichtet ist, umfasst.

3. Wärmeableitungsstruktur nach Anspruch 1, wobei die Seitenwände glatte Wände oder gewellte Wände umfassen.

4. Wärmeableitungsstruktur nach Anspruch 3, wobei gerippte Strukturen oder strömungsstörende Strukturen ferner an den Seitenwänden eingerichtet sind.

5. Schrank (21), umfassend einen Ventilator und die Wärmeableitungsstruktur nach einem der Ansprüche 1 bis 4, wobei der Ventilator in einem internen Zirkulationslüftungskanal der Wärmeableitungsstruktur eingerichtet ist.

6. Kommunikationssystem, umfassend den Schrank (21) nach Anspruch 5 und eine elektronische Vorrichtung (22), die innerhalb des Schranks (21) montiert ist.

## Revendications

1. Structure de dissipation thermique, conçue afin de dissiper la chaleur pour un dispositif électronique (22) monté à l'intérieur d'un caisson (21), et comprenant un boîtier du caisson (21),
un premier évent (A1) et un second évent (A2) qui ont des hauteurs différentes étant disposés sur le boîtier, et le premier évent (A1) et le second évent (A2) communiquant avec l'extérieur du caisson (21) ;
le boîtier comprenant 2N+1 couches de panneaux latéraux, les 2N+1 couches de panneaux latéraux comprenant un panneau latéral de couche extérieure (211) et des panneaux latéraux de couche intérieure 2N, ayant un espace entre deux panneaux latéraux voisins, et les panneaux latéraux de couche intérieure 2N étant regroupés en N groupes de panneaux latéraux de couche intérieure dans une séquence d'agencement, N étant un entier positif ;
lorsque N est égal à 1, un premier espace (B1) entre un premier panneau latéral de couche intérieure et le panneau latéral de couche extérieure (211) communiquant avec l'intérieur du caisson (21), pour former un canal de ventilation de circulation intérieure ; ou
lorsque N est supérieur à 1, un premier espace (B1) entre deux panneaux latéraux de couche intérieure voisins dans des groupes différents et un premier espace (B1) entre le premier panneau latéral de couche intérieure et le panneau latéral de couche extérieure (211) communiquant les uns avec les autres, et communiquant avec l'intérieur du caisson (21), pour former un canal de ventilation de circulation intérieure, et le premier panneau latéral de couche intérieure étant un panneau latéral de couche intérieure qui est le plus éloigné du dispositif électronique (22) dans les panneaux latéraux de couche intérieure 2N ; et
lorsque N est égal à 1, un deuxième espace (B2) entre les deux panneaux latéraux de couche intérieure communiquant avec le premier évent (A1) et le second évent (A2), pour former un canal de ventilation de circulation extérieure ; et lorsque N est supérieur à 1, les deuxièmes espaces (B2), dont chacun se trouve entre deux panneaux latéraux de couche intérieure dans un même groupe, communiquant entre eux, et communiquant avec le premier évent (A1) et le second évent (A2), pour former un canal de ventilation de circulation extérieure ; et
la structure de dissipation thermique comprenant en outre des panneaux de blocage d'air (26) ;
les panneaux de blocage d'air (26) étant disposés entre les extrémités supérieures de deux panneaux latéraux de couche intérieure formant le deuxième espace (B2) et entre les extrémités inférieures des deux panneaux latéraux de couche intérieure formant le deuxième espace (B2) ; et
un troisième espace (B3) se trouvant entre les extrémités supérieures des panneaux latéraux formant le premier espace (B1) et un panneau supérieur du boîtier, un quatrième espace (B4) se trouvant entre les extrémités inférieures des panneaux latéraux formant le premier espace (B1) et un panneau inférieur du boîtier, et le troisième espace (B3) et le quatrième espace (B4) communiquant tous deux avec l'intérieur du caisson (21) ; et
**caractérisée en ce que**
le premier évent (A1) et le second évent (A2) sont disposés sur le panneau latéral de couche extérieure (211), et la structure de dissipation thermique comprend en outre des structures de déflexion d'air tubulaires (27) ;
un troisième trou traversant et un quatrième trou traversant qui ont des hauteurs différentes sont disposés sur un panneau latéral de couche intérieure autre qu'un second panneau latéral de couche intérieure dans les panneaux latéraux de couche intérieure 2N, et le second panneau latéral de couche intérieure est un panneau latéral de couche intérieure qui est le plus proche du dispositif électronique (22) dans les panneaux latéraux de couche intérieure 2N ; et
lorsque N est égal à 1, l'une des structures de déviation d'air (27) est reliée entre un troisième trou traversant du premier panneau latéral de couche intérieure et le premier évent (A1), et une autre des structures de déviation d'air (27) est reliée entre un quatrième trou traversant du premier panneau latéral de couche intérieure et le second évent (A2) ; ou
lorsque N est supérieur à 1, l'une des structures de déviation d'air (27) est reliée entre un troisième trou traversant du premier panneau latéral de couche intérieure et le premier évent (A1), une autre des structures de déviation d'air (27) est reliée entre un quatrième trou traversant du premier panneau latéral de couche intérieure et le second évent (A2), une autre des structures de déviation d'air (27) est reliée entre les troisièmes trous traversants de deux panneaux latéraux de couche intérieure voisins dans différents des groupes, et une autre des structures de déflexion d'air (27) est reliée entre des quatrièmes trous traversants des deux panneaux latéraux de couche intérieure voisins dans les différents groupes.

2. Structure de dissipation thermique selon la revendication 1, dans laquelle la structure de dissipation thermique comprend en outre un ventilateur disposé dans le canal de ventilation à circulation extérieure.

3. Structure de dissipation thermique selon la revendication 1, dans laquelle les panneaux latéraux comprennent des panneaux lisses ou des panneaux ondulés.

4. Structure de dissipation thermique selon la revendication 3, dans laquelle des structures à branchies ou des structures perturbant l'écoulement sont en outre disposées sur les panneaux latéraux.

5. Caisson (21), comprenant un ventilateur et la structure de dissipation thermique selon l'une quelconque des revendications 1 à 4, le ventilateur étant disposé dans un canal de ventilation à circulation intérieure de la structure de dissipation thermique.

6. Système de communication, comprenant le caisson (21) selon la revendication 5 et un dispositif électronique (22) monté à l'intérieur du caisson (21).
